Europäisches Patentamt

European Patent Office

Office européen des brevets

(19)

(11) Veröffentlichungsnummer: **0 107 771**
**B1**

(12) **EUROPÄISCHE PATENTSCHRIFT**

(45) Veröffentlichungstag der Patentschrift:
**12.03.86**

(51) Int. Cl.⁴: **G 01 R 1/073, G 01 R 31/28**

(21) Anmeldenummer: **83109002.2**

(22) Anmeldetag: **12.09.83**

(54) **Anordnung für die Prüfung von Mikroverdrahtungen und Verfahren zu ihrem Betrieb.**

(30) Priorität: **22.09.82 DE 3235119**

(43) Veröffentlichungstag der Anmeldung:
**09.05.84 Patentblatt 84/19**

(45) Bekanntmachung des Hinweises auf die Patenterteilung:
**12.03.86 Patentblatt 86/11**

(84) Benannte Vertragsstaaten:
**DE FR GB NL**

(56) Entgegenhaltungen:
**US - A - 4 114 093**
**US - A - 4 138 186**

(73) Patentinhaber: **Siemens Aktiengesellschaft, Berlin und München Wittelsbacherplatz 2, D-8000 München 2 (DE)**

(72) Erfinder: **Lischke, Burkhard, Prof. Dr., In der Heuluss 13, D-8000 München 82 (DE)**
Erfinder: **Frosien, Jürgen, Dr. Ing., An der Ottosäule 18, D.8012 Ottobrunn (DE)**
Erfinder: **Schmitt, Reinhold, Dipl.-Ing., Tucholskystrasse 18, D-8000 München 83 (DE)**

ACTORUM AG

(4) durch eine leitende Flüssigkeit (L) vor mechanischer Beschädigung geschützt sind.

5. Anordnung nach einem der Ansprüche 1 bis 4, dadurch gekennzeichnet, dass pro Prüfkontakt (4) sowohl für positive als auch für negative Prüfspannung jeweils ein eigener Schalter (2, 33) vorgesehen ist.

6. Anordnung nach einem der Ansprüche 1 bis 5, dadurch gekennzeichnet, dass die Prüfkontakte (4) mit je einem Schalter $(S(X_n, Y_m))$ matrixförmig angeordnet sind.

7. Verfahren zum Betrieb einer Anordnung nach Anspruch 6, dadurch gekennzeichnet, dass zwei Prüfkontakte $(X_1Y_1, X_2Y_2)$ dadurch mit einer Prüfspannung versorgt werden, dass zeilenweise alle Schalter $(S(X_n, Y_m))$ einer jeden Spalte bis $Y_1$ bzw. $Y_2$ geschlossen werden und dass sodann an die Spalten $(X_1$ und $X_2)$ durch Schliessen der entsprechenden Schalter (V, W) die Prüfspannung angelegt wird.

8. Verfahren zum Betrieb einer Anordnung nach Anspruch 6, dadurch gekennzeichnet, dass zwei Prüfkontakte $(X_1Y_1, X_2Y_2)$ dadurch mit einer Prüfspannung versorgt werden, dass spaltenweise alle Schalter $(S(X_n, Y_m))$ einer jeden Zeile bis $X_1$ bzw. $X_2$ geschlossen werden und dass sodann an die Zeilen $(Y_1$ und $Y_2)$ durch Schliessen der entsprechenden Schalter die Prüfspannung angelegt wird.

## Claims

1. An arrangement for electrically testing microcircuit components by means of electrical test contacts which can be selected by means of internal switches, characterized in that the test contacts (4) are arranged in a matrix whose grid dimension corresponds to the grid dimension of a printed circuit board to be tested, and that lines (5, 6, 15, 16, 25, 26, 36), which are embedded in a substrate (9) and serve to supply the test voltages to the selected test contacts (4), are switched through to the surface (12) of the arrangement by means of switches $(2, 3, 33, S(X_n, Y_m), V, W)$.

2. An arrangement as claimed in Claim 1, characterized in that the electrical test contacts (4) are produced in planar technology.

3. An arrangement as claimed in one of Claims 1 or 2, characterized in that the electrical test contacts (4) are photolithographically produced.

4. An arrangement as claimed in one of Claims 1 to 3, characterized in that the test contacts (4) are protected against mechanical damage by a conductive liquid (L).

5. An arrangement as claimed in one of Claims 1 to 4, characterized in that for each test contact (4) a separate switch (2, 33) is provided for positive and for negative test voltages respectively.

6. An arrangement as claimed in one of Claims 1 to 5, characterized in that the test contacts (4), each of which has a switch $(S(X_n, Y_m))$, are arranged so as to be matrix-shaped.

7. A process for the operation of an arrangement as claimed in Claim 6, characterized in that two test contacts $(X_1Y_1, X_2Y_2)$ are supplied with a test voltage, in that all switches $(S(S_n, Y_m))$ of each column to $Y_1$ or $Y_2$, as the case may be, are closed line-by-line, and that by closing the corresponding switches (V, W) the test voltage is then connected to the columns $(X_1$ and $X_2)$.

8. A process for the operation of an arrangement as claimed in Claim 6, characterized in that two test contacts $(X_1Y_1, X_2Y_2)$ are supplied with a test voltage, in that all switches $(S(S_n, Y_m))$ of each row to $X_1$ or $X_2$, as the case may be, are closed row-by-row, and that by closing the corresponding switches the test voltage is then connected to the rows $(Y_1$ and $Y_2)$.

## Revendications

1. Dispositif pour réaliser le contrôle électrique de microcircuits comportant des contacts électriques de contrôle, qui peuvent être sélectionnés par l'intermédiaire de commutateurs internes, caractérisé par le fait que les contacts de contrôle (4) sont disposés dans une matrice dont le pas du réseau correspond au pas du réseau d'une plaquette à circuits imprimés devant être contrôlée, et que les conducteurs (5, 6, 15, 16, 25, 26, 36) logés dans un substrat et servant à appliquer les tensions de contrôle sont interconnectés aux points de contrôle sélectionnés (4) par l'intermédiaire des commutateurs $(2, 3, 33, S(X_n, Y_m), V, W)$ sur la surface (12) du dispositif.

2. Dispositif suivant la revendication 1, caractérisé par le fait que les contacts de contrôle électrique (4) sont fabriqués selon la technique planar.

3. Dispositif suivant l'une des revendications 1 ou 2, caractérisé par le fait que les contacts électriques de contrôle (4) sont réalisés par voie photolithographique.

4. Dispositif suivant l'une des revendications 1 à 3, caractérisé par le fait que les contacts de contrôle (4) sont protégés vis-à-vis d'un endommagement mécanique par un liquide conducteur (L).

5. Dispositif suivant l'une des revendications 1 à 4, caractérisé par le fait qu'il est prévu un commutateur propre (2, 33) respectivement pour chaque contact de contrôle (4) aussi bien pour une tension de contrôle positive que pour une tension de contrôle négative.

6. Dispositif suivant l'une des revendications 1 à 5, caractérisé par le fait que les contacts de contrôle (4) comportant respectivement un commutateur $[S(X_n, Y_m)]$ sont disposés sous la forme d'une matrice.

7. Procédé pour faire fonctionner un dispositif suivant la revendication 6, caractérisé par le fait qu'on alimente deux contacts de contrôle $(X_1, Y_1, X_2, Y_2)$ avec une tension de contrôle de telle sorte que tous les commutateurs $[S(Y_n, Y_m)]$ de chaque colonne, hormis $Y_1$ ou $Y_2$, sont fermés ligne par ligne et qu'alors la tension de contrôle est appliquée aux colonnes $(X_1$ et $X_2)$ par fermeture des commutateurs (V, W) correspondants.

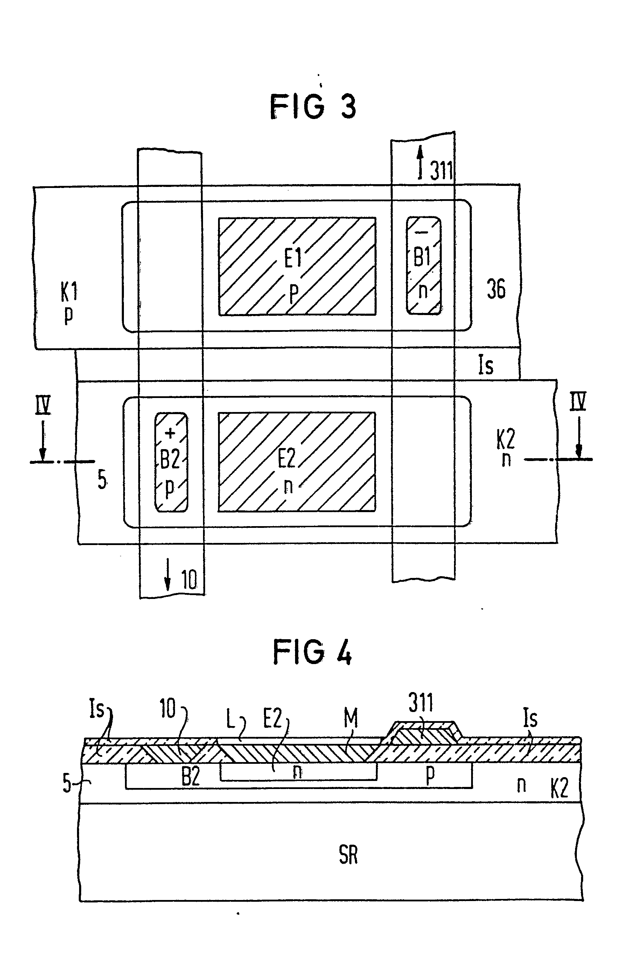

8. Procédé pour faire fonctionner un dispositif eine Leitung 5 mit negativem Prüfpotential und eine Leitung 36 mit positivem Prüfpotential. Der Knoten nach Fig. 3 weist einen pnp-Transistor 33 und einen npn-Transistor 2 auf. Die Basis B1 des pnp-Transistors 33 wird über die Leitung 311 angesteuert. Die Basis B2 des npn-Transistors 2 wird über die Leitung 10 angesteuert. Der pnp-Transistor 33 weist ausserdem einen Kollektor K1 und einen Emitter E1 auf. Der Kollektor K1 ist im Bereich des Knotens der Schaltmatrix identisch mit der Leitung 36. Der Transistor 33 wird dadurch durchgeschaltet, dass die Basis B1 mit entsprechender negativer Spannung angesteuert wird.

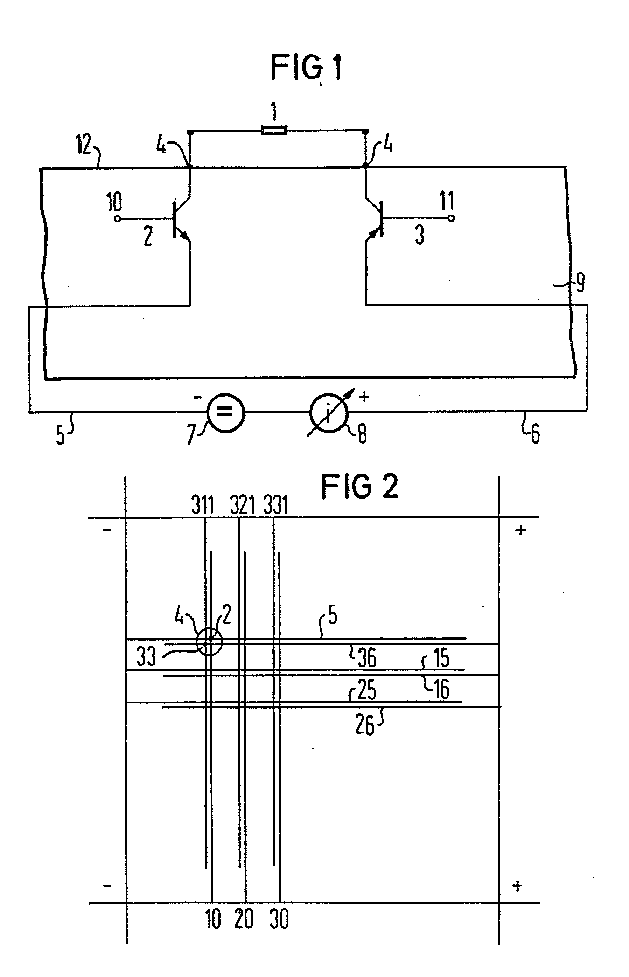

Der npn-Transistor in Fig. 3 entspricht dem Transistor 2 von Fig. 1 und Fig. 2 und weist eine Basis B2, einen Emitter E2 und einen Kollektor K2 auf. Im Bereich des Knotens nach Fig. 3 ist der Kollektor K2 identisch mit der Stromleitung 5. Dieser Transistor 2 wird bei Ansteuerung der Basis B2 mit entsprechender positiver Spannung durchgeschaltet.

Fig. 4 zeigt einen Querschnitt durch den npn-Transistor von Fig. 3. Nach Fig. 4 weist eine erfindungsgemässe Anordnung für die elektrische Prüfung Mikroverdrahtungen ein Substrat SR aus reinem Silizium auf. Im Bereich des Knotens nach Fig. 3 ist direkt auf dieses Substrat SR ein n-Halbleiter für den Kollektor K2 und für die Stromleitung 5 aufgebracht. Darüber ist ein p-Halbleiter für die Basis B2 eingebettet. Darin wiederum ist ein n-Halbleiter für den Emitter E2 eingebettet. Oberhalb der Basis B2 ist auf einer Seite die Steuerleitung 10 angeordnet. Auf der anderen Seite der Basis B2 befindet sich ein Isolator Is und darüber die Steuerleitung 311 für die Basis B1 des pnp-Transistors, der zusammen mit dem npn-Transistor einen Knoten gemäss Fig. 3 bildet. Die Steuerleitungen 10 und 311 sind gegen Luft isoliert. Auf dem Emitter E2 ist bei dem Beispiel nach Fig. 4 ein metallischer Kontakt M aufgebracht, der zusammen mit einem auf dem Emitter E1 des pnp-Transistors aufgebrachten metallischen Kontakt genau einen Prüfkontakt 4 einer erfindungsgemässen Anordnung für die elektrische Prüfung von Mikroverdrahtungen definiert. Als Fläche für den Prüfkontakt 4 steht dabei etwas weniger zur Verfügung, als durch das Rastermass einer erfindungsgemässen Anordnung nach Fig. 2 vorgegeben ist. Eine Anordnung nach Fig. 4 mit zwei tiefgesetzten metallischen Kontakten M oberhalb des Emitters E1 und oberhalb des Emitters E2 ermöglicht einen weichen Kontakt am Prüfkontakt 4 über eine leitende Flüssigkeit, z.B. über einen Elektrolyten. Dabei werden die Kontakte einer zu prüfenden Mikroverdrahtung in besonderer Weise vor mechanischer Beschädigung geschützt. Für direkten mechanischen Kontakt am Prüfkontakt 4 müsste der in Fig. 4 dargestellte metallische Kontakt etwas erhaben sein.

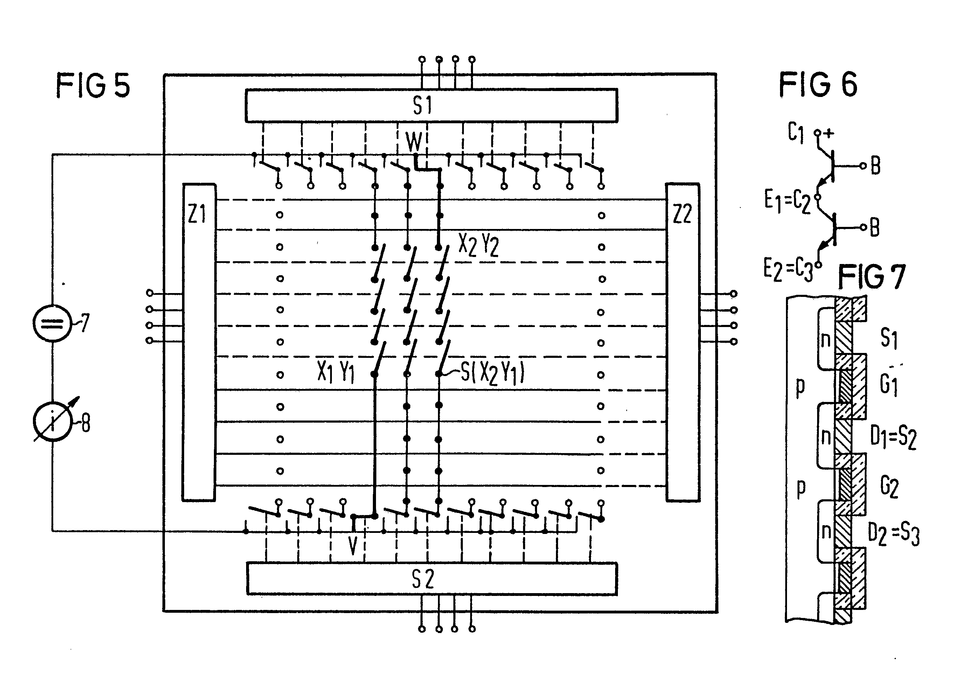

Fig. 5 zeigt eine Anordnung zum Testen von Mikroverdrahtungen mit Hilfe einer Schaltmatrix. Jeder Prüfpunkt mit den Koordinaten $X_n$, $Y_m$ weist in diesem Beispiel ein Paar $S(X_nY_m)$ von Schaltern auf.

Fig. 5 zeigt eine Anordnung zum Testen von Mikroverdrahtungen mit Hilfe einer Schaltmatrix. Jeder Prüfpunkt mit den Koordinaten $X_n$, $Y_m$ weist in diesem Beispiel ein Paar $S(X_nY_m)$ von Schaltern. Die Prüfpunkt $X_1Y_1$ und $X_2Y_2$ werden dadurch mit Spannung versorgt, dass alle gleichartigen Schalter der Schalterpaare $S(X_nY_m)$ entsprechend den zu prüfenden Spannungen bis $Y_1$ bzw. $Y_2$ durch die Zeilendecoder $Z_1$, $Z_2$ geschlossen werden. Die Spaltendecoder $S_1$, $S_2$ wählen sodann die Spalten $X_1$ und $X_2$ aus. Durch Schliessen der entsprechenden Schalter V, W durch die Spaltendecoder $S_1$, $S_2$ wird die Prüfspannung der Gleichspannungsquelle 7 an die ausgewählten Prüfkontakte $X_1Y_1$, $X_2Y_2$ angelegt.

Fig. 6 zeigt eine mögliche Realisierung für die Schalter $S(X_nY_m)$ durch bipolare Transistoren. Gleichartige npn-Transistoren sind in Fig. 6 in Reihe geschaltet, wobei jeweils der Emitter $E_i$ an den Kollektor $C_{i+1}$ des folgenden Transistors angeschlossen ist. Die Transistoren von Fig. 6 werden von den Zeilendecodern $Z_1$, $Z_2$ über die jeweiligen Basiskontakte B gesteuert.

Fig. 7 zeigt eine mögliche Realisierung für die Schalter $S(X_nY_m)$ von Fig. 5 durch MOS-Transistoren. In diesem Beispiel sind wiederum npn-Transistoren hintereinandergeschaltet, wobei jeweils die Drain-Elektrode $D_i$ eines Transistors mit der Source-Elektrode $S_{i+1}$ des folgenden Transistors übereinstimmt. Die Zeilendecoder $Z_1$, $Z_2$ steuern diese Transistoren über die Gate-Elektroden $G_i$.

Für die Prüfung der Mikroverdrahtungen muss grundsätzlich vor Beginn der Prüfung eine erfindungsgemässe Testplatte gegen den Prüfling ausgerichtet werden. Darstellungen spezieller Transistoren oder Layouts in den Bildern beschränken die Anwendung der Erfindung nicht auf die dargestellten Ausführungsbeispiele. Die in einer Schaltmatrix angeordneten Schalter können auch auf andere Art und Weise realisiert werden.

## Patentansprüche

1. Anordnung für die elektrische Prüfung von Mikroverdrahtungen mit elektrischen Prüfkontakten, die über interne Schalter auswählbar sind, dadurch gekennzeichnet, dass die Prüfkontakte (4) in einer Matrix angeordnet sind, deren Rastermass dem Rastermass einer zu prüfenden Leiterplatte entspricht, und dass die in einem Substrat (9) eingebetteten Leitungen (5, 6, 15, 16, 25, 26, 36) zur Zuführung der Prüfspannungen an den ausgewählten Prüfkontakten (4) über die Schalter (2, 3, 33, $S(X_n, Y_m)$, V, W) an die Oberfläche (12) der Anordnung durchgeschaltet sind.

2. Anordnung nach Anspruch 1, dadurch gekennzeichnet, dass die elektrischen Prüfkontakte (4) in Planartechnik hergestellt sind.

3. Anordnung nach einem der Ansprüche 1 oder 2, dadurch gekennzeichnet, dass die elektrischen Prüfkontakte (4) fotolithografisch hergestellt sind.

4. Anordnung nach einem der Ansprüche 1 bis 3, dadurch gekennzeichnet, dass die Prüfkontakte suivant la revendication 6, caractérisé par le fait qu'on alimente deux contacts de contrôle ($X_1$, $Y_1$, $X_2$, $Y_2$) avec une tension de contrôle de telle sorte que tous les commutateurs [$S(X_n, Y_m)$] de chaque ligne, hormis $X_1$ ou $X_2$, sont fermés colonne par colonne et qu'alors la tension de contrôle est appliquée aux lignes ($Y_1$ et $Y_2$) par fermeture des commutateurs correspondants.

# FIG 1

# FIG 2

# FIG 3

K1
p

E1
P

B1
n

36

Is

IV

B2
p

E2
n

K2
n

IV

5

10

311

# FIG 4

Is  10  L  E2  M  311  Is

5  B2  n  p  n  K2

SR

FIG 5

FIG 6

FIG 7